# EUROPÄISCHE PATENTSCHRIFT

(11) **EP 0 560 724 B1**
(45) Veröffentlichungstag und Bekanntmachung des Hinweises auf die Patenterteilung: **24.09.1997**
(21) Anmeldenummer: 93810162.3
(22) Anmeldetag: 04.03.1993
(51) Int. Cl.: C07F 9/6568, G03F 7/029, C08F 2/50

(54) **Benzoyl substituierte Phosphabicycloalkane und -sulfide als Photoinitiatoren**
Benzoyl substituted phosphabicycloalcanes and their sulphides as photoinitiators
Phosphabicycloalcanes et leurs sulfures portant un substituant benzoyle comme photoinitiateurs

(30) Priorität: 11.03.1992 CH 786/92
(43) Veröffentlichungstag der Anmeldung: 15.09.1993
(73) Patentinhaber: Ciba Specialty Chemicals Holding Inc., 4057 Basel (CH)
(72) Erfinder: Leppard, David G., Dr., CH-1723 Marly (CH); Misev, Ljubomir, Dr., CH-4123 Allschwil (CH); Hug, Gebhard, CH-1700 Fribourg (CH)

(56) Entgegenhaltungen:
- EP-A- 0 047 902
- EP-A- 0 413 657
- Houben-Weyl, Band E20/1, 1987

## Beschreibung

Die Erfindung betrifft Benzoyl-substituierte Phosphabicycloalkane und -sulfide, deren Verwendung als Initiatoren zur Photopolymerisation ethylenisch ungesättigter Verbindungen und Zusammensetzungen enthaltend Benzoyl-substituierte Phosphabicycloalkane und -sulfide.

Monoacylphosphinoxide und ihre Verwendung als Photoinitiatoren sind beispielsweise aus den US-A-4 298 738 und EP-A-40 721 sowie einer grossen Zahl weiterer Veröffentlichungen dem Fachmann allgemein bekannt. Im US-A-4 522 693 ist die Herstellung von Acylphosphinsulfiden und deren Verwendung als Photoinitiatoren beschrieben. In der EP-A-413 657 sind erstmals Benzoyl-substituierte Phosphabicycloalkanoxid Verbindungen mitumfasst, die photoinitiierende Eigenschaften aufweisen.

In der Technik besteht weiterhin ein Bedarf an wirksamen Photohärtern.

Es wurde nun überraschend gefunden, dass Benzoyl-substituierte Phosphabicycloalkane und -sulfide sehr gute photohärtende Eigenschaften besitzen.

Die Erfindung betrifft daher Verbindungen der Formel I 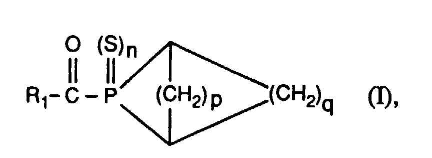 worin
n 0 oder 1 bedeutet,
p für eine Zahl von 1 bis 8 steht,
q 2 oder 3 ist und
R₁ unsubstituiertes oder mit Halogen, C₁-C₈-Alkyl, C₁-C₈-Alkoxy, C₂-C₈-Alkoxyalkyl oder/und C₁-C₄-Alkylthio substituiertes Phenyl bedeutet.

Substituiertes Phenyl ist ein- oder mehrfach, besonders ein- bis dreifach, z.B. ein- oder zweifach, vorzugsweise zwei- oder dreifach substituiert.

Mit Halogen substituiertes Phenyl ist mit Cl, Br, F oder Iod, vorzugsweise mit Cl substituiert Z.B. Chlorphenyl, 2,4- oder 2,6-Dichlorphenyl, 2,4,6-Trichlorphenyl, 2,4- oder 2,6-Dibromphenyl, 2,4,6-Tribromphenyl, 2,4- oder 2,6-Difluorphenyl, 2,4,6-Trifluorphenyl. Vorzugsweise ist mit Halogen substituiertes Phenyl mit Chlor substituiert.

C₁-C₈-Alkyl Substituenten am Phenyl können verzweigt oder unverzweigt sein und sind beispielsweise Methyl, Ethyl, Propyl, Isopropyl, n-Butyl, sec-Butyl, tert-Butyl, Pentyl, Hexyl, Heptyl oder Octyl, insbesondere Methyl. Entsprechende Reste sind z.B. Tolyl, Mesityl, Xylyl, Ethylphenyl oder tert.Butylphenyl, insbesondere Mesityl.

Mit C₁-C₈-Alkoxy substituiertes Phenyl ist z.B. Methoxyphenyl, Dimethoxyphenyl, Methoxyethoxyphenyl, Ethoxyphenyl, Propyloxyphenyl, Methoxyisopropyloxyphenyl, Butoxyphenyl, Dibutoxyphenyl oder Hexyloxyphenyl, insbesondere 2,6-Dimethoxyphenyl.

Phenyl mit C₂-C₈-Alkoxyalkyl substituiert ist beispielsweise Methoxymethylphenyl, Methoxyethylphenyl, Ethoxymethylphenyl, Dimethoxymethylphenyl, Dimethoxyethylphenyl, Diethoxymethylphenyl, Methoxyethylphenyl oder Ethoxyethylphenyl.

Mit C₁-C₄-Alklythio substituiertes Phenyl ist z.B. Methylthiophenyl, Ethylthiophenyl, Propylthiophenyl, Isopropylthiophenyl, Butylthiophenyl oder tert.Butylthiophenyl.

Das substituierte Phenyl kann auch mehrere verschiedene der oben erwähnten Substituenten tragen wie z.B. 2,4-Dibutoxy-6-methylphenyl, 2,4-Dimethoxy-6-methylphenyl, 2,6-Dimethoxy-4-methylphenyl, 2,4-Diethoxy-6-methylphenyl, 2,4-Diisopropyloxy-6-methylphenyl.

Bevorzugt sind Verbindungen der Formel I, worin R₁ für einen Rest der Formel II steht 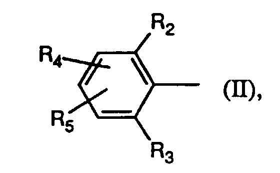 worin R₂ und R₃ unabhängig voneinander Halogen, insbesondere Cl, C₁-C₄-Alkyl oder C₁-C₄-Alkoxy bedeuten und
R₄ und R₅ unabhängig voneinander für Halogen, insbesondere Cl, C₁-C₄-Alkyl, C₁-C₄-Alkoxy oder Wasserstoff stehen.

Weitere interessante Verbindungen der Formel I sind solche, worin R₄ C₁-C₄-Alkyl, C₁-C₄-Alkoxy oder Wasserstoff darstellt und R₅ Wasserstoff ist.

Insbesondere sind solche Verbindungen der Formel I bevorzugt, worin R₂ und R₃ unabhängig voneinander C₁-C₄-Alkyl, insbesondere Methyl, oder C₁-C₄-Alkoxy, insbesondere Methoxy, bedeutet, R₄ Wasserstoff oder C₁-C₄-Alkyl, insbesondere Methyl, ist und R₅ für Wasserstoff steht.

Interessante Verbindungen der Formel I sind solche, worin R₄ die para-Stellung des Phenylringes einnimmt.

Ausserdem bevorzugt sind die Verbindungen der Formel I, worin p 1 bis 4, insbesondere 3 und 4, ist.

Besonders bevorzugt sind Verbindungen der Formel I, worin n 1 ist.

Beispiele für Verbindungen der Formel I sind
9-(2,6-Dimethoxybenzoyl)-9-phosphabicyclo[4.2.1]nonan
9-(2,6-Dimethoxybenzoyl)-9-phosphabicyclo[3.3.1]nonan
9-(2,4,6-Trimethylbenzoyl)-9-phosphabicyclo[4.2.1]nonan
9-(2,4,6-Trimethylbenzoyl)-9-phosphabicyclo[3.3.1]nonan
9-(2,6-Dichlorbenzoyl)-9-phosphabicyclo[4.2.1]nonan
9-(2,6-Dichlorbenzoyl)-9-phosphabicyclo[3.3.1]nonan
9-(2,4-Dibutoxy-6-methylbenzoyl)-9-phosphabicyclo[4.2.1]nonan
9-(2,4-Dibutoxy-6-methylbenzoyl)-9-phosphabicyclo[3.3.1]nonan
9-(2,4-Dimethoxy-6-methylbenzoyl)-9-phosphabicyclo[4.2.1]nonan
9-(2,4-Dimethoxy-6-methylbenzoyl)-9-phosphabicyclo[3.3.1]nonan
7-(2,6-Dimethoxybenzoyl)-7-phosphabicyclo[2.2.1]heptan
7-(2,4,6-Trimethylbenzoyl)-7-phosphabicyclo[2.2.1]heptan
7-(2,6-Dichlorbenzoyl)-7-phosphabicyclo[2.2.1]heptan
7-(2,4-Dibutoxy-6-methylbenzoyl)-7-phosphabicyclo[2.2.1]heptan
7-(2,4-Dimethoxy-6-methylbenzoyl)-7-phosphabicyclo[2.2.1]heptan
9-(2,6-Dimethoxybenzoyl)-9-phosphabicyclo[4.2.1]nonan-9-sulfid
9-(2,6-Dimethoxybenzoyl)-9-phosphabicyclo[3.3.1]nonan-9-sulfid
9-(2,4,6-Trimethylbenzoyl)-9-phosphabicyclo[4.2.1]nonan-9-sulfid
9-(2,4,6-Trimethylbenzoyl)-9-phosphabicyclo[3.3.1]nonan-9-sulfid
9-(2,6-Dichlorbenzoyl)-9-phosphabicyclo[4.2.1]nonan-9-sulfid
9-(2,6-Dichlorbenzoyl)-9-phosphabicyclo[3.3.1]nonan-9-sulfid
9-(2,4-Dibutoxy-6-methylbenzoyl)-9-phosphabicyclo[4.2.1]nonan-9-sulfid
9-(2,4-Dibutoxy-6-methylbenzoyl)-9-phosphabicyclo[3.3.1]nonan-9-sulfid
9-(2,4-Dimethoxy-6-methylbenzoyl)-9-phosphabicyclo[4.2.1]nonan-9-sulfid
9-(2,4-Dimethoxy-6-methylbenzoyl)-9-phosphabicyclo[3.3.1]nonan-9-sulfid
7-(2,6-Dimethoxybenzoyl)-7-phosphabicyclo[2.2.1]heptan-7-sulfid
7-(2,4,6-Trimethylbenzoyl)-7-phosphabicyclo[2.2.1]heptan-7-sulfid
7-(2,6-Dichlorbenzoyl)-7-phosphabicyclo[2.2.1]heptan-7-sulfid
7-(2,4-Dibutoxy-6-methylbenzoyl)-7-phosphabicyclo[2.2.1]heptan-7-sulfid
7-(2,4-Dimethoxy-6-methylbenzoyl)-7-phosphabicyclo[2.2.1]heptan-7-sulfid

Die Verbindungen der Formel I (Ia: n=0, Ib: n=1), können hergestellt werden durch Reaktion eines bicyclischen Phosphans (II) mit einem Carbonsäurechlorid (III) in Gegenwart einer Base. Die Sulfide (Ib) werden durch anschliessende Umsetzung der Verbindungen der Formel (Ia) mit einer äquimolaren Menge elementarem Schwefel erhalten. Die Reaktionen sind im folgenden Schema dargestellt:

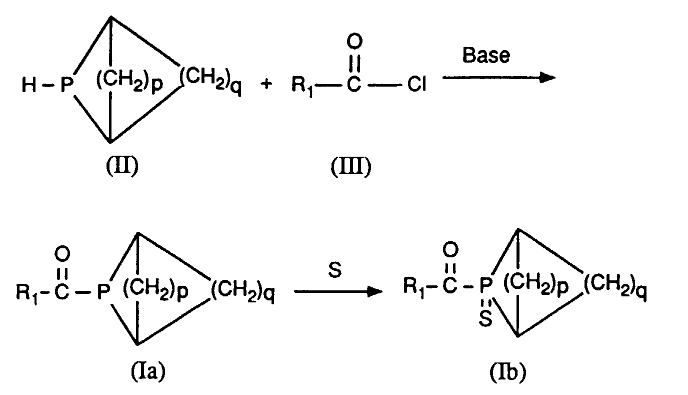

R₁, p und q haben die gleichen Bedeutungen wie in Anspruch 1 definiert. Die Umsetzungen erfolgen vorzugsweise in einem geeigneten Lösemittel. Sofern die Komponenten II und III flüssig sind, ist es auch möglich, den ersten Reaktionsschritt ohne Lösemittel durchzuführen. Geeignete Lösemittel sind vor allem Kohlenwasserstoffe wie Alkane und Alkangemische, Cyclohexan, Benzol, Toluol oder Xylol. Die Reaktion wird je nach Lösemittel und verwendeten Edukten zweckmässig bei 10-120°C, vorzugsweise 20-80 °C, ausgeführt. Falls ein Lösemittel verwendet wird, wird dieses am Ende der jeweiligen Reaktion abdestilliert. Die rohen Reaktionsprodukte können z.B. durch Destillation, Kristallisation oder Chromatographie gereinigt werden.
Die Herstellung des Sulfids kann beispielsweise in Analogie zu der in der DE-A-3 034 697 beschriebenen Methode erfolgen. Die Reaktion wird zweckmässig in einer Inertgasatmosphäre aus z.B. Stickstoff, Argon oder Kohlendioxid, vorzugsweise Stickstoff, durchgeführt. Nach der Umsetzung kann es nötig sein, das entstandene Sulfid bzw. dessen Lösung durch Filtration von gegebenenfalls noch vorhandenem Schwefel abzutrennen.

Als Base eignen sich z.B. Alkali- oder Erdalkalimetallcarbonate, tertiäre Amine, Alkalimetalle, Lithiumdiisopropylamid, Alkalialkoholate oder Alkalihydride.

Die Herstellung der bicyclischen Phosphane (II) ist beispielsweise in JP-A-80 123 790 beschrieben. Einige dieser Verbindungen oder Gemische davon sind auch im Handel erhältlich. Die Phosphane können z.B. durch Addition von Phosphin an ein Dien (IV) erhalten werden:

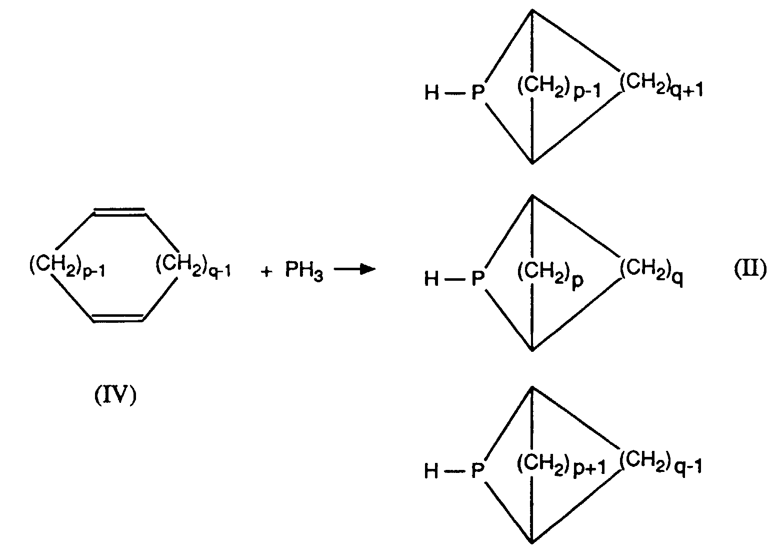

Die Ringgrösse des Diens (IV) ist p + q + 2, wobei p und q wie in Anspruch 1 definiert sind.

Die als Ausgangsmaterial verwendeten Diene (IV) sind bekannte, zum Teil kommerziell erhältliche Verbindungen oder können in Analogie zu bekannten Verbindungen hergestellt werden. Auch die Herstellung der Säurechloride der Formel (III) erfolgt nach bekannten Methoden aus dem Stand der Technik.

In der Praxis geht man häufig von Isomerengemischen von Verbindungen der Formel II aus, da solche bei der Addition des Phosphins an Verbindungen der Formel IV hauptsächlich entstehen, wie in obiger Reaktionsgleichung gezeigt. Man erhält dann zwangsläufig auch Gemische von Verbindungen der Formel I, die ebenfalls von Anspruch 1 umfasst werden. Formal sind diese Gemische durch die Formel I beschrieben, worin p und q nicht ganzzahlig sind. Besagte Gemische können aber auch, wenn erwünscht, nach üblichen Methoden getrennt werden, z.B. durch Chromatographie. In der Praxis können jedoch die Gemische als solche als Photoinitiatoren eingesetzt werden.

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden.

Die Erfindung betrifft daher auch photopolymerisierbare Zusammensetzungen, enthaltend
(a) mindestens eine ethylenisch ungesättigte photopolymerisierbare Verbindung und
(b) als Photoinitiator mindestens eine Verbindung der Formel I,
wobei die Zusammensetzung ausserdem noch mindestens einen weiteren Photoinitiator und/oder andere Additive enthalten kann.

Die ungesättigten Verbindungen können eine oder mehrere olefinische Doppelbindungen enthalten. Sie können niedermolekular (monomer) oder höhermolekular (oligomer) sein.

Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Weitere Beispiele hierfür sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol- oder Bisphenol-A-diacrylat, 4,4'-Bis(2-acryloyloxyethoxy)-diphenylpropan, Trimethylolpropan-triacrylat, Pentaerythritol-triacrylat oder -tetraacrylat, Pentaerythritoldivinylether, Vinylacrylat, Divinylbenzol, Divinylsuccinat, Diallylphthalat, Triallylphosphat, Triallylisocyanurat oder Tris-(2-acryloylethyl)isocyanurat.

Beispiele für höhermolekulare (oligomere) mehrfach ungesättigte Verbindungen sind acrylierte Epoxidharze, acrylierte Polyether, acrylierte Polyurethane oder acrylierte Polyester. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Solche ungesättigte Oligomere kann man auch als Prepolymere bezeichnen.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Polybutadien und Butadien. Copolymere, Polyisopren und Isopren-Copolymere, Polymere und Coplymere mit (Meth)Acrylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Tri-ethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind:
Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdiinethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldiitaconat, Sorbittriacrylat, Sorbittetraacrylat, Pentaerythrit-modifiziert-triacrylat, Sorbittetramethacrylat, Sorbitpentaacrylat, Sorbithexaacrylat, Oligoesteracrylate und -methacrylate, Glycerindi- und -triacrylat, 1,4-Cyclohexandiacrylat, Bisacrylate und Bismethacrylate von Polyethylenglykol mit Molekulargewicht von 200 bis 1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di-(β-aminopropoxy)ethan. Weitere geeignete Polyamine sind Polymere und Copolymere mit gegebenenfalls zusätzlichen Aminogruppen in der Seitenkette und Oligoamide mit Aminoendgruppen. Beispiele für solche ungesättigten Amide sind:
Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N [(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolakbasis mit (Meth)-Acrylsäure handeln, um Homo- oder Copolymere des Vinylalkohols oder deren Hydroxyalkylderivaten, die mit (Meth)-Acrylsäure verestert sind, oder um Homo- und Copolymere von (Meth)-Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt Die Menge des Bindemittels kann z.B. 5-95, vorzugsweise 10-90 und besonders 40-90 Gew.-% betragen, bezogen auf den Gesamtfestkörper. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000- 1 000 000. Beispiele sind: Homo- und Copolymere Acrylate und Methacrylate, z.B. Copolymere aus Methylmethacrylat/Ethylacrylat/Methacrylsäure, Poly(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polymere wie Polycaprolactam und Poly(hexamethylenadipamid), Polyester wie Poly(ethylenglykolterephtalat) und Poly(hexamethylenglykolsuccinat).

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösemitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die photopolymerisierbaren Gemische können ausser dem Photoinitiator verschiedene Additive enthalten. Beispiele hierfür sind thermische Inhibitoren, die eine vorzeitige Polymerisation verhindern sollen, wie z.B. Hydrochinon, Hydrochinonderivate, p-Methoxyphenol, β-Naphthol oder sterisch gehinderte Phenole wie z.B. 2,6-Di(tert-butyl)-p-kresol. Zur Erhöhung der Dunkellagerstabilität können z.B. Kupferverbindungen, wie Kupfernaphthenat, -stearat oder -octat, Phosphorverbindungen, wie z.B. Triphenylphosphin, Tributylphosphin, Triethylphosphit, Triphenylphosphit oder Tribenzylphosphit, quartäre Ammoniumverbindungen, wie z.B. Tetramethylammoniumchlorid oder Trimethyl-benzylammoniumchlorid, oder Hydroxylaminderivate, wie z.B. N-Diethylhydroxylamin verwendet werden. Zwecks Ausschluss des Luftsauerstoffes während der Polymerisation kann man Paraffin oder ähnliche wachsartige Stoffe zusetzen, die bei Beginn der Polymerisation wegen mangelnder Löslichkeit im Polymeren an die Oberfläche wandern und eine transparente Oberflächenschicht bilden, die den zutritt von Luft verhindert. Als Lichtschutzmittel können in geringer Menge UV-Absorber, wie z.B. solche vom Benztriazol-, Benzophenon-, Oxalanilid- oder Hydroxyphenyl-S-triazin-Typ, zugesetzt werden. Noch besser ist der Zusatz von Lichtschutzmitteln, die UV-Licht nicht absorbieren, wie z.B. von sterisch gehinderten Aminen (HALS).

Zur Beschleunigung der Photopolymerisation können Amine zugesetzt werden, wie z.B. Triethanolamin, N-Methyl-diethanolamin, p-Dimethylaminobenzoesäure-ethylester oder Michlers Keton. Die Wirkung der Amine kann verstärkt werden durch den Zusatz von aromatischen Ketonen vom Typ des Benzophenons.
Eine Beschleunigung der Photopolymerisation kann weiterhin durch Zusatz von Photosensibilisatoren geschehen, welche die spektrale Empfindlichkeit verschieben bzw. verbreitern. Dies sind insbesondere aromatische Carbonylverbindungen wie z.B. Benzophenon-Thioxanthon-, Anthrachinon- und 3-Acylcumarinderivate sowie 3-(Aroylmethylen)-thiazoline.

Weitere übliche Zusätze sind - je nach Verwendungszweck - optische Aufheller, Füllstoffe, Pigmente, Farbstoffe, Netzmittel oder Verlaufhilfsmittel.
Zur Härtung dicker und pigmentierter Beschichtungen eignet sich der Zusatz von Mikro-Glaskugeln oder pulverisierter Glasfasern, wie z.B. im US-A-5 013 768 beschrieben.

Gegenstand der Erfindung sind auch Zusammensetzungen enthaltend als Komponente (a) mindestens eine in Wasser gelöste oder emulgierte ethylenisch ungesättigte photopolymerisierbare Verbindung.

Solche strahlungshärtbaren wässrigen Prepolymerdispersionen sind in vielen Variationen im Handel erhältlich. Man versteht darunter eine Dispersion aus Wasser und mindestens einem darin dispergierten Prepolymeren. Die Konzentration des Wassers in diesen Systemen liegt z.B. bei 5 bis 80, insbesondere 30 bis 60 Gew.-%. Das strahlungshärtbare Prepolymere bzw. Prepolymerengemisch ist beispielsweise in Konzentrationen von 95 bis 20, insbesondere 70 bis 40 Gew.-% enthalten. In diesen Zusammensetzungen ist die Summe der für Wasser und Prepolymere genannten Prozentzahlen jeweils 100, die Hilfsund Zusatzstoffe kommen, je nach Verwendungszweck, in unterschiedlichen Mengen hinzu.

Bei den strahlungshärtbaren, in Wasser dispergierten, oft auch gelösten filmbildenden Prepolymeren handelt es sich um für wässrige Prepolymerdispersionen an sich bekannte, durch freie Radikale initiierbare mono- oder polyfunktionelle ethylenisch ungesättigte Prepolymere, die beispielsweise einen Gehalt von 0,01 bis 1,0 Mol pro 100 g Prepolymer an polymerisierbaren Doppelbindungen, sowie ein mittleres Molekulargewicht von z.B. mindestens 400, insbesondere von 500 bis 10000 aufweisen. Je nach Anwendungszweck kommen jedoch auch Prepolymere mit höheren Molekulargewichten in Frage. Es werden beispielsweise polymerisierbare C-C-Doppelbindungen enthaltende Polyester mit einer Säurezahl von höchstens 10, polymerisierbare C-C-Doppelbindungen enthaltende Polyether, hydroxylgruppenhaltige Umsetzungsprodukte aus einem mindestens zwei Epoxidgruppen pro Molekül enthaltenden Polyepoxid mit mindestens einer α,β-ethylenisch ungesättigten Carbonsäure, Polyurethan(meth-)acrylate sowie α,β-ethylenisch ungesättigte Acrylreste enthaltende Acrylcopolymere verwendet, wie sie in der EP-A-12 339 beschrieben sind. Gemische dieser Prepolymeren können ebenfalls verwendet werden. In Frage kommen ausserdem die in der EP-A-33 896 beschriebenen polymerisierbaren Prepolymere, bei denen es sich um Thioetheraddukte von polymerisierbaren Prepolymeren mit einem mittleren Molekulargewicht von mindestens 600, einem Carboxylgruppengehalt von 0,2 bis 15 % und einem Gehalt von 0,01 bis 0,8 Mol polymerisierbarer C-C-Doppelbindungen pro 100 g Prepolymer handelt. Andere geeignete wässrige Dispersionen auf Basis von speziellen (Meth-)-Acrylsäurealkylester-Polymerisaten sind in der EP-A-41 125 beschrieben, geeignete in Wasser dispergierbare, strahlungshärtbare Prepolymere aus Urethanacrylaten sind der DE-A-29 36 039 zu entnehmen.
Als weitere Zusätze können diese strahlungshärtbaren wässrigen Prepolymerdispersionen Dispergierhilfsmittel, Emulgatoren, Antioxidantien, Lichtstabilisatoren, Farbstoffe, Pigmente, Füllstoffe, z.B. Talkum, Gips, Kieselsäure, Rutil, Russ, Zinkoxid, Eisenoxide, Reaktionsbeschleuniger, Verlaufsmittel, Gleitmittel, Netzmittel, Verdickungsmittel, Mattierungsmittel, Entschäumer und andere in der Lacktechnologie übliche Hilfsstoffe enthalten. Als Dispergierhilfsmittel kommen wasserlösliche hochmolekulare organische Verbindungen mit polaren Gruppen, wie z.B. Polyvinylalkohole, Polyvinylpyrrolidon oder Celluloseether in Frage. Als Emulgatoren können nicht-ionische, gegebenenfalls auch ionische Emulgatoren verwendet werden.

Die photopolymerisierbaren Zusammensetzungen enthalten den Photoinitiator (b) zweckmässig in einer Menge von 0,05 bis 15 Gew.-%, vorzugsweise 0,2 bis 5 Gew.-%, bezogen auf die Zusammensetzung.

In bestimmten Fällen kann es von Vorteil sein, Gemische von zwei oder mehr der erfindungsgemässen Photoinitiatoren zu verwenden. Selbstverständlich können auch Gemische mit bekannten Photoinitiatoren verwendet werden, z.B. Gemische mit Benzophenon, Acetophenonderivaten, wie beispielsweise α-Hydroxyalkylphenylketonen, Benzoinalkylethern und Benzilketalen, Acylphosphinoxiden, Bisacylphosphinoxiden, Perestern oder Titanocenen.

Bevorzugt sind Zusammensetzungen, worin die Komponente (b) ein Gemisch aus isomeren Verbindungen der Formel I mit unterschiedlichen p- und q-Werten ist.

Die photopolymerisierbaren Zusammensetzungen können für verschiedene Zwecke verwendet werden, beispielsweise als Druckfarbe, als Klarlack, als Weisslack, z.B. für Holz oder Metall, als Anstrichstoff, u.a. für Papier, Holz, Metall oder Kunststoff, als tageslichthärtbarer Anstrichstoff für Bautenanstriche und Strassenmarkierungen, als Druckfarbe, für photographische Reproduktionsverfahren, für Bildaufzeichnungsverfahren oder zur Herstellung von Druckplatten, die mit organischen Lösemitteln oder wässrig-alkalisch entwickelbar sind, zur Herstellung von Masken für den Siebdruck, als Zahnfüllmassen, als Klebstoffe, als Aetz- oder Permanentresists und als Lötstoppmasken für elektronische Schaltungen, zur Herstellung von dreidimensionalen Gegenständen durch Massenhärtung (UV-Härtung in transparenten Formen) oder nach dem Stereolithographie-Verfahren, wie es z.B. im US-Patent Nr. 4,575,330 beschrieben ist, zur Herstellung von Verbundwerkstoffen (z.B. styrolischen Polyestern, die gegebenenfalls Glasfasern und andere Hilfsstoffe enthalten können) und anderen dickschichtigen Massen, zur Beschichtung oder Versiegelung von elektronischen Teilen oder als Ueberzüge für optische Fasern.

In Lacken verwendet man häufig Gemische eines Prepolymeren mit mehrfach ungesättigten Monomeren, die ausserdem noch ein einfach ungesättigtes Monomer enthalten können. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwendet muss.

Ungesättigte Polyesterharze werden meist in Zweikomponentensystemen zusammen mit einem einfach ungesättigten Monomer, vorzugsweise mit Styrol, verwendet. Für Photo-resists werden oft spezifische Einkomponentensysteme verwendet, wie z.B. Polymaleinimide, Polychalkone oder Polyimide, wie sie in der DE-OS 2 308 830 beschrieben sind.

Die erfindungsgemässen photohärtbaren Zusammensetzungen eignen sich z.B. als Beschichtungsstoffe für Substrate aller Art, z.B. Holz, Papier, Keramik, Kunststoffe wie Polyester und Celluloseacetatfilme und Metalle wie Kupfer und Aluminium, bei denen durch Photopolymerisation eine Schutzschicht oder eine Abbildung aufgebracht werden soll.
Die Beschichtung der Substrate kann erfolgen, indem man eine flüssige Zusammensetzung, eine Lösung oder Suspension auf das Substrat aufbringt. Das geschieht z.B. durch Tauchen, Aufpinseln, Spritzen oder Reverseroll-Beschichtung. Die Auftragsmenge (Schichtdicke) und Art des Substrates (Schichtträger) sind abhängig vom gewünschten Applikationsgebiet. Als Schichtträger für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 µm. Bei Mitverwenden von Lösungsmitteln werden diese nach dem Beschichten entfernt.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Farben von Bedeutung.

Gut geeignet sind die erfindungsgemässen Gemische auch zur Herstellung von Druckplatten. Hierbei werden z. B. Gemische von löslichen linearen Polyamiden oder Styrol/Butadien Kautschuk mit photopolymerisierbaren Monomeren, beispielsweise Acrylamiden oder Acrylestern, und einem Photoinitiator verwendet. Filme und Platten aus diesen Systemen (nass oder trocken) werden über das Negativ (oder Positiv) der Druckvorlage belichtet und die ungehärteten Teile anschliessend mit einem geeigneten Lösemittel eluiert.

Ein weiteres Einsatzgebiet der Photohärtung ist die Metallbeschichtung, beispielsweise bei der Lackierung von Blechen und Tuben, Dosen oder Flaschenverschlüssen, sowie die Photohärtung auf Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplattenhüllen oder Buchumschlägen.

Wichtig ist auch die Verwendung von photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösemittel (=Entwickler) entfernt. Das Aufbringen der photohärtbaren Schicht kann auch im Elektroabscheidungsverfahren auf Metall geschehen. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte elektronische Schaltungen und Photoresists herstellen.

Die Polymerisation erfolgt nach den bekannten Methoden der Photopolymerisation durch Bestrahlung mit Sonnenlicht oder mit Licht, das reich an kurzwelliger Strahlung ist. Als Lichtquellen sind z.B. Quecksilbermitteldruck-, -hochdruck- und -niederdruckstrahler, superaktinische Leuchtstoffröhren, Metallhalogenid-Lampen oder Laser geeignet, deren Emissionsmaxima im Bereich zwischen 200 und 450 nm liegen. Laserlichtquellen haben den Vorteil, dass keine Photomasken notwendig sind, da der gesteuerte Laserstrahl direkt auf die photohärtbare Schicht schreibt. In bestimmten Fällen können auch längerwelliges Licht oder Laserstrahlen bis 600 nm verwendet werden.

Gegenstand der Erfindung ist auch ein Verfahren zur Photopolymerisation von Verbindungen mit ethylenisch ungesättigten Doppelbindungen, dadurch gekennzeichnet, dass man eine wie oben beschriebene Zusammensetzung mit Licht im Bereich von 200 bis 600 nm bestrahlt.

Erfindungsgemäss ist auch eine gehärtete Zusammensetzung, erhalten nach dem oben beschriebenen Verfahren.

Die nachfolgenden Beispiele erläutern die Erfindung weiter. Angaben in Teilen oder Prozenten beziehen sich, ebenso wie in der übrigen Beschreibung und in den Patentansprüchen, auf das Gewicht, sofern nichts anderes angegeben ist.

### Beispiel 1:

### A) Herstellung von 9-(2,6-Dimethoxybenzoyl)-9-phosphabicyclo[4.2.1]nonan und 9-(2,6-Dimethoxybenzoyl)-9-phosphabicyclo[3.3.1]nonan

Zu 25,6 g (0,10 mol, 55,5 % in Toluol) eines Isomerengemisches aus 9*H*-Phosphabicyclo[4.2.1]nonan und 9*H*-Phosphabicyclo[3.3.1]nonan (®Phoban; HOECHST) und 30,4 g (0,22 mol) Kaliumcarbonat in 100 ml Toluol wird bei 20-30 °C innerhalb von 60 min eine Lösung aus 22,1 g (0,11 mol) 2,6-Dimethoxybenzoylchlorid in 50 ml Toluol getropft. Zur Vervollständigung der Reaktion wird noch 2 h bei unveränderter Temperatur gerührt. Das Reaktionsgemisch wird einmal mit Wasser gewaschen, die organische Phase abgetrennt und mit Magnesiumsulfat getrocknet. Nach dem Einengen wird der Rückstand aus Essigester umkristallisiert. Es resultieren 11,3 g (36,9 % d. Theorie) der Titelverbindungen im Verhältnis 1:4 als gelbliches Pulver mit einem Schmelzpunkt von 119-122 °C.

| Elementaranalyse: | | | | | |
|---|---|---|---|---|---|
| ber. | C | 66,65% | gef. | C | 66,34% |
| | H | 7,57% | | H | 7,10% |

### B) Herstellung von 9-(2,6-Dimethoxybenzoyl)-9-phosphabicyclo[4.2.1]nonan-9-sulfid und 9-(2,6-Dimethoxybenzoyl)-9-phosphabicyclo[3.3.1]nonan-9-sulfid

7,7 g (0,025 mol) eines Isomerengemisches aus 9-(2,6-Dimethoxybenzoyl)-9-phosphabicyclo[4.2.1]nonan und 9-(2,6-Dimethoxybenzoyl)-9-phosphabicyclo[3.3.1]nonan werden in 50 ml Toluol vorgelegt und unter Einleiten von Stickstoff auf 60 °C erwärmt, wobei sich das Edukt vollständig löst. Bei 60 °C werden 0,8 g (0,025 mol) Schwefel zugegeben und die Reaktionsmischung 6 h nachgerührt. Nach dem Abkühlen auf Raumtemperatur wird am Vakuum eingeengt und der Rückstand aus Essigester umkristallisiert. Es resultieren 6,5 g (76,7 % d. Theorie) der Titelverbindungen im Verhältnis 1:6 als gelbliches Pulver mit einem Schmelzpunkt von 135-140 °C.

| Elementaranalyse: | | | | | |
|---|---|---|---|---|---|
| ber. | C | 60,34% | gef. | C | 60,17% |
| | H | 6,85% | | H | 6,75% |
| | S | 9,47% | | S | 9,74% |

### Beispiel 2: Herstellung von

9-(2,4,6-Trimethylbenzoyl)-9-phosphabicyclo[4.2.1]nonansulfid und
9-(2,4,6-Trimethylbenzoyl)-9-phosphabicyclo[3.3.1]nonansulfid

Zu 25,6 g (0,10 mol, 55,5 % in Toluol) eines Isomerengemisches aus 9*H*-Phosphabicyclo[4.2.1]nonan und 9*H*-Phosphabicyclo[3.3.1]nonan (®Phoban; HOECHST) und 30,4 g (0,22 mol) Kaliumcarbonat in 150 ml Toluol wird bei 20-30 °C innerhalb von 30 min eine Lösung aus 20,1 g (0,11 mol) 2,4,6-Trimethylbenzoylchlorid in 50 ml Toluol getropft. Zur Vervollständigung der Reaktion wird noch 10 h bei unveränderter Temperatur gerührt. Das Reaktionsgemisch wird einmal mit Wasser gewaschen, die organische Phase abgetrennt, mit Magnesiumsulfat getrocknet und filtriert. Die so erhaltene gelbliche Lösung wird unter Einleiten von Stickstoff auf 60 °C erwärmt und bei dieser Temperatur mit 3,2 g (0,10 mol) Schwefel versetzt. Nach 3 h Rühren wird auf Raumtemperatur abgekühlt und die gelbe Lösung im Vakuum eingeengt. Nach Reinigung des Isomerengemisches mittels Chromatographie Laufmittel: Hexan/Diisopropylether 9:1) und anschliessender Umkristallisation aus einem Hexan/Essigester Gemisch resultieren 5,0 g (15,6 % d. Theorie) 9-(2,4,6-Trimethylbenzoyl)-9-phosphabicyclo[3.3.1]nonansulfid (I) als gelbes Pulver mit einem Schmelzpunkt von 94-95 °C und 2,8 g (8,8 % d.Theorie) 9-(2,4,6-Trimethylbenzoyl)-9-phosphabicyclo[4.2.1]nonansulfid (II) mit einem Schmelzpunkt von 142-144 °C.

| Elementaranalyse: | | | | | | |
|---|---|---|---|---|---|---|
| (I) | ber. | C | 67,47% | gef. | C | 67,34% |
| | | H | 7,86% | | H | 7,91% |
| | | S | 10.01% | | S | 10,40% |
| (II) | ber. | C | 67,47% | gef. | C | 65,83% |
| | | H | 7,86% | | H | 8,01% |
| | | S | 10,01% | | S | 12,61% |

### Beispiel 3: Reaktivität in einem Weisslack

Ein UV-härtbarer Weisslack wird hergestellt durch Mischen von

| | |
|---|---|
| 67,5 Teilen | Polyesteracrylat Oligomer (®Ebecryl 830, UCB, Belgien) |
| 5,0 Teilen | Hexandioldiacrylat |
| 2,5 Teilen | Trimethylolpropantriacrylat |
| 25,0 Teilen | Rutil-Titandioxid (®R-TC2, Tioxide, Frankreich) |
| 2,0 Teilen | Photoinitiator |

Der Lack wird mit einer 100 µm Spaltrakel auf ein Coil-Coat Blech aufgetragen und anschliessend gehärtet Die Härtung erfolgt, indem die Probe auf einem Förderband, welches mit einer Geschwindigkeit von 10 m/min bewegt wird, unter einer 80 W/cm Mitteldruck-Quecksilberlampe (Hanovia, USA) durchgeführt wird Ermittelt wird die Wischfestigkeit (WF) als Anzahl der Durchläufe (n), die notwendig ist um eine wischfeste Oberfläche zu erhalten. Weiterhin wird die Pendelhärte (PH) nach König (DIN 53157) in [s] bestimmt Dies geschieht zunächst bei der wischfesten Oberfläche und dann nach einer zusätzlichen Belichtung von 15 min unter Niederdruck-Quecksilberlampen des Typs TL 40/03 (Philips; Emissionsmaximum bei 430 nm). Das Ergebnis ist in der Tabelle 2 wiedergegeben.

**Tabelle 2:**

| Photoinitiator aus Bsp. | WF n x 10m/min | PH[s] bei WF | PH[s] nach 15 min |
|---|---|---|---|
| 1B | 5 | 126 | 142 |

## Patentansprüche

1. Verbindungen der Formel I 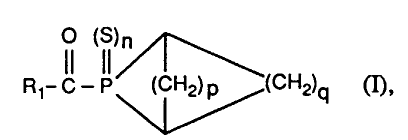 worin
n 0 oder 1 bedeutet,
p für eine Zahl von 1 bis 8 steht,
q 2 oder 3 ist und
R₁ unsubstituiertes oder mit Halogen, C₁-C₈-Alkyl, C₁-C₈-Alkoxy, C₂-C₈-Alkoxyalkyl oder/und C₁-C₄-Alkylthio substituiertes Phenyl bedeutet.

2. Verbindungen nach Anspruch 1, worin R₁ für einen Rest der Formel II steht 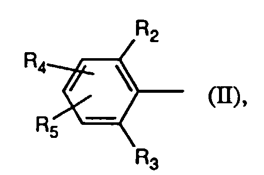 worin R₂ und R₃ unabhängig voneinander Halogen, insbesondere Cl, C₁-C₄-Alkyl oder C₁-C₄-Alkoxy bedeuten und
R₄ und R₅ unabhängig voneinander für Halogen, insbesondere Cl, C₁-C₄-Alkyl, C₁-C₄-Alkoxy oder Wasserstoff stehen.

3. Verbindungen nach Anspruch 2, worin R₄ C₁-C₄-Alkyl, C₁-C₄-Alkoxy oder Wasserstoff darstellt und R₅ Wasserstoff ist.

4. Verbindungen nach Anspruch 2, worin R₂ und R₃ unabhängig voneinander C₁-C₄-Alkyl, insbesondere Methyl, oder C₁-C₄-Alkoxy, insbesondere Methoxy, bedeutet, R₄ Wasserstoff oder C₁-C₄-Alkyl, insbesondere Methyl, ist und R₅ für Wasserstoff steht.

5. Verbindungen nach einem der Ansprüche 2-4, worin R₄ die para-Stellung des Phenylringes einnimmt.

6. Verbindungen nach einem der Ansprüche 1-5, worin p 1 bis 4 ist.

7. Verbindungen der Formel I nach Anspruch 1, worin n 1 ist.

8. Photopolymerisierbare Zusammensetzung enthaltend
(a) mindestens eine ethylenisch ungesättigte photopolymerisierbare Verbindung und
(b) als Photoinitiator mindestens eine Verbindung der Formel I.

9. Photopolymerisierbare Zusammensetzung nach Anspruch 8, enthaltend als Komponente (a) mindestens eine in Wasser gelöste oder emulgierbare ethylenisch ungesättigte photopolymerisierbare Verbindung.

10. Zusammensetzung nach einem der Ansprüche 8 oder 9, worin die Komponente (b) ein Gemisch aus isomeren Verbindungen der Formel I mit unterschiedlichen p- und q-Werten ist.

11. Zusammensetzung nach einem der Ansprüche 8- 10, dadurch gekennzeichnet, dass sie neben dem Photoinitiator (b) noch mindestens einen weiteren Photoinitiator und/oder andere Additive enthält.

12. Zusammensetzung nach einem der Ansprüche 8-11, enthaltend 0,05 bis 15, insbesondere 0,2 bis 5 Gew.-% der Komponente (b), bezogen auf die Zusammensetzung.

13. Verfahren zur Photopolymerisation von Verbindungen mit ethylenisch ungesättigten Doppelbindungen, dadurch gekennzeichnet, dass man eine Zusammensetzung nach einem der Ansprüche 8-12 mit Licht im Bereich von 200 bis 600 nm bestrahlt.

14. Gehärtete Zusammensetzung, erhalten nach dem Verfahren gemäss Anspruch 13.

15. Verwendung von Verbindungen der in Anspruch 1 definierten Formel I als Photoinitiatoren für die Photopolymerisation ethylenisch ungesättigter Verbindungen.

16. Verwendung einer Zusammensetzung nach einem der Ansprüche 8-12 zur Herstellung von Anstrichstoffen, insbesondere Weisslacken für Holz- und Metallanstriche oder Klarlacken, zur Herstellung von Anstrichstoffen für tageslichthärtbare Bautenanstriche und Strassenmarkierungen, zur Herstellung von Druckfarben, als Zahnfüllmassen, zur Herstellung von dreidimensionalen Gegenständen durch Massenhärtung oder Stereolithographie, zur Herstellung von Verbundwerkstoffen, zur Herstellung von Druckplatten, zur Herstellung von Masken für den Siebdruck, zur Herstellung von Photoresists für gedruckte elektronische Schaltungen, zur Herstellung von Klebstoffen, als Beschichtung oder Versiegelung von elektronischen Teilen oder als Ueberzug für optische Fasern.

17. Verfahren nach Anspruch 13 zur Härtung von Anstrichstoffen, insbesondere Weisslacken für Holz- und Metallanstriche oder Klarlacken, zur Härtung von Anstrichstoffen für tageslichthärtbare Bautenanstriche und Strassenmarkierungen, zur Härtung von Druckfarben, zur Härtung von Zahnfüllmassen, zur Herstellung von dreidimensionalen Gegenständen durch Massenhärtung oder Stereolithographie, zur Herstellung von Verbundwerkstoffen, zur Herstellung von Druckplatten, zur Herstellung von Masken für den Siebdruck, zur Herstellung von Photoresists für elektronische Schaltungen, zur Herstellung von Klebstoffen, zur Herstellung von Beschichtungen oder Versiegelungen von elektronischen Teilen oder zur Herstellung von Ueberzugen für optische Fasern.

## Claims

1. A compound of formula I 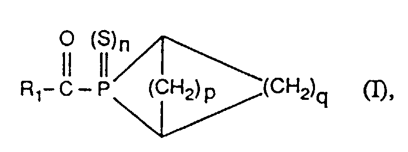 wherein
n is 0 or 1,
p is a number from 1 to 8,
q is 2 or 3, and
R₁ is unsubstituted phenyl or phenyl which is substituted by halogen, C₁-C₈alkyl, C₁-C₈alkoxy, C₂-C₈alkoxyalkyl or/and C₁-C₄alkylthio.

2. A compound according to claim 1, wherein R₁ is a radical of the formula II 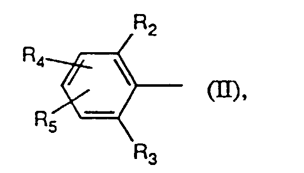 wherein R₂ and R₃ are each independently of the other halogen, especially Cl, C₁-C₄alkyl or C₁-C₄alkoxy, and
R₄ and R₅ are each independently of the other halogen, especially Cl, C₁-C₄alkyl, C₁-C₄alkoxy or hydrogen.

3. A compound according to claim 2, wherein R₄ is C₁-C₄alkyl, C₁-C₄alkoxy or hydrogen and R₅ is hydrogen.

4. A compound according to claim 2, wherein R₂ and R₃ are each independently of the other C₁-C₄alkyl, especially methyl, or C₁-C₄alkoxy, especially methoxy, R₄ is hydrogen or C₁-C₄alkyl, especially methyl, and R₅ is hydrogen.

5. A compound according to any one of claims 2 to 4, wherein R₄ is in the para-position of the phenyl ring.

6. A compound according to any one of claims 1 to 5, wherein p is 1 to 4.

7. A compound of formula I according to claim 1, wherein n is 1.

8. A photopolymerizable composition comprising
(a) at least one ethylenically unsaturated photopolymerizable compound, and
(b) at least one compound of formula I as photoinitiator.

9. A photopolymerizable composition according to claim 8, comprising as component (a) at least one ethylenically unsaturated photopolymerizable compound which is dissolved in or emulsifiable in water.

10. A composition according to either claim 8 or claim 9, wherein component (b) is a mixture of isomers of the compound of formula I in which p and q have different values.

11. A composition according to any one of claims 8 to 10, which, in addition to the photoinitiator (b), comprises at least one further photoinitiator and/or other additives.

12. A composition according to any one of claims 8 to 11 comprising 0.05 to 15% by weight, especially 0.2 to 5% by weight, of component (b), based on the composition.

13. A process for photopolymerizing a compound which contains ethylenically unsaturated double bonds, which comprises irradiating a composition according to any one of claims 8 to 12 with light in the range from 200 to 600 nm.

14. A cured composition obtained by the process of claim 13.

15. Use of a compound of formula I as defined in claim 1 as photoinitiator for photopolymerizing ethylenically unsaturated compounds.

16. Use of a composition according to any one of claims 8 to 12 for the preparation of coating formulations, especially of white coating materials for coating wood or metal, or transparent coating materials, of daylight-curable coating formulations for construction coatings and road markings, of printing ink formulations, for dental filling compositions, for the preparation of three-dimensional objects by mass hardening or stereolithography, of composites, of printing plates, of masks for screen printing, of photoresists for printed electronic circuits, of adhesives, and for coating or sealing electronic components or for coating optical fibres.

17. A process according to claim 13 for curing coating formulations, especially white coating materials for coating wood or metal, or transparent coating materials, daylight-curable coating formulations for construction coatings and road markings, printing ink formulations, dental filling compositions, for the preparation of three-dimensional objects by mass hardening or stereolithography, of composites, of printing plates, of masks for screen printing, of photoresists for electronic circuits, of adhesives, and for the preparation of coats and sealants for electronic components or for the preparation of coatings for optical fibres.

## Revendications

1. Composés de formule I 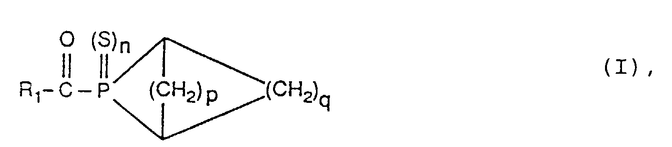 dans laquelle
n vaut 0 ou 1,
p est un nombre de 1 à 8,
q vaut 2 ou 3 et
R₁ représente un phényle non substitué ou substitué par halogène, alkyle en C₁-C₈, alcoxy en C₁-C₈, alcoxyalkyle en C₂-C₈ et/ou alkylthio en C₁-C₄.

2. Composés selon la revendication 1 où R₁ représente un reste de formule II 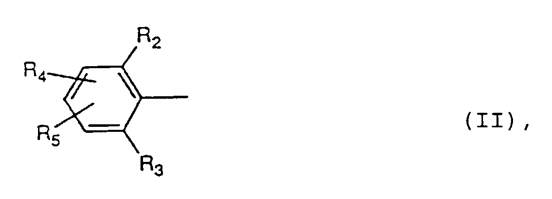 dans laquelle
R₂ et R₃, indépendamment l'un de l'autre, représentent halogène, plus particulièrement Cl, alkyle en C₁-C₄ ou alcoxy en C₁-C₄ et
R₄ et R₅, indépendamment l'un de l'autre, représentent halogène, plus particulièrement Cl, alkyle en C₁-C₄, alcoxy en C₁-C₄ ou l'hydrogène.

3. Composés selon la revendication 2, où R₄ représente alkyle en C₁-C₄, alcoxy en C₁-C₄ ou l'hydrogène et R₅ est l'hydrogène.

4. Composés selon la revendication 2, où R₂ et R₃, indépendamment l'un de l'autre, sont alkyle en C₁-C₄, plus particulièrement méthyle, ou alcoxy en C₁-C₄, plus particulièrement méthoxy, R₄ représente l'hydrogène ou alkyle en C₁-C₄, plus particulièrement méthyle et R₅ représente l'hydrogène.

5. Composés selon l'une des revendications 2 à 4, où R₄ est en position para sur le cycle phényle.

6. Composés selon l'une des revendications 1 à 5, où p va de 1 à 4.

7. Composés de formule I selon la revendication 1, où n vaut 1.

8. Composition photopolymérisable contenant
(a) au moins un composé photopolymérisable à insaturation éthylénique et
(b) en tant que photoamorceurs, au moins un composé de formule I.

9. Composition photopolymérisable selon la revendication 8, contenant en tant que composant (a) au moins un composé photopolymérisable à insaturation éthylénique émulsionnable ou dissous dans l'eau.

10. Composition selon l'une des revendications 8 ou 9, où le composant (b) est un mélange de composés isomères de formule I ayant des valeurs de p et q différentes.

11. Composition selon l'une des revendications 8 à 10, caractérisée en ce qu'elle contient au côté du photoamorceur (b) encore au moins un autre photoamorceur et/ou d'autres additifs.

12. Composition selon l'une des revendications 8 à 11, contenant de 0,05 à 15, plus particulièrement de 0,2 à 5 % en poids du composant (b) par rapport à la composition.

13. Procédé de photopolymérisation de composés comportant des doubles liaisons à insaturation éthylénique, caractérisé en ce que l'on irradie une composition selon l'une des revendications 8 à 12 par la lumière dans l'intervalle de 200 à 600 nm.

14. Composition durcie obtenue selon le procédé de la revendication 13.

15. Utilisation des composés de formule I, définis dans la revendication 1, en tant que photoamorceurs pour la photopolymérisation de composés à insaturation éthylénique.

16. Utilisation d'une composition selon l'une des revendications 8 à 12 pour la préparation d'enduits, plus particulièrement de vernis incolores pour les enduits de bois et de métaux ou de vernis transparents pour la préparation d'enduits de bâtiment et de marquages de chaussées durcissables à la lumière du jour, pour la préparation d'encres d'imprimerie, en tant que matières de dentisterie, pour la préparation d'objets tridimensionnels par durcissement en masse ou pour la stéréolithographie, pour la préparation de matériaux composites, pour la préparation de clichés d'imprimerie, pour la préparation de masques pour la sérigraphie, pour la préparation de photorésists pour circuits électroniques imprimés, pour la préparation d'adhésifs, en tant qu'enduit ou scellement de composants électroniques ou pour le revêtement de fibres optiques.

17. Procédé selon la revendication 13, pour le durcissement d'enduits, plus particulièrement de vernis incolores pour le bois ou des métaux ou de vernis transparent pour le durcissement d'enduits pour les marquages de chaussées et d'enduits de bâtiment durcissables à la lumière du jour, pour le durcissement d'encres d'imprimerie, pour le durcissement de matières de dentisterie, pour la préparation d'objets tridimensionnels par durcissement en masse ou pour la stéréolithographie, pour la préparation de matériaux composites, pour la préparation de clichés d'imprimerie, pour la préparation de masques pour la sérigraphie, pour la préparation de photorésists pour circuits électroniques imprimés, pour la préparation d'adhésifs, pour la préparation de revêtements ou de scellements de composants électroniques ou pour la préparation de revêtement de fibres optiques.
